# EUROPÄISCHE PATENTSCHRIFT

(11) **EP 3 997 968 B1**
(45) Veröffentlichungstag und Bekanntmachung des Hinweises auf die Patenterteilung: **13.08.2025**
(21) Anmeldenummer: 20734147.0
(22) Anmeldetag: 18.06.2020
(51) Int. Cl.: H05K 3/22, H05K 13/04, H01L 23/00, H05K 3/34

(54) **VERFAHREN ZUM ENTFERNEN EINES AUF EINER LEITERPLATTE AUFGEBRACHTEN BAUTEILS**
METHOD FOR REMOVING A COMPONENT APPLIED TO A PRINTED CIRCUIT BOARD
PROCÉDÉ POUR RETIRER UN COMPOSANT INSTALLÉ SUR UNE CARTE DE CIRCUITS IMPRIMÉS

(30) Priorität: 09.07.2019 DE 102019118573
(43) Veröffentlichungstag der Anmeldung: 18.05.2022
(73) Patentinhaber: Endress+Hauser SE+Co. KG, 79689 Maulburg (DE)
(72) Erfinder: HIPPIN, Christoph, 79639 Grenzach (DE)
(74) Vertreter: Endress + Hauser Group Services (Deutschland) AG+Co. KG
(86) Internationale Anmeldenummer: PCT/EP2020/066950
(87) Internationale Veröffentlichungsnummer: WO 2021/004751

(56) Entgegenhaltungen:
- EP-A1- 0 548 603
- EP-B1- 0 548 603
- DE-A1- 3 414 485

## Beschreibung

Die Erfindung betrifft ein Verfahren zum Entfernen eines auf einer Leiterplatte aufgebrachten Bauteils, wobei das Bauteil ein Gehäuse und eine Vielzahl von Anschlüssen aufweist, wobei jedes der Bauteile über eine separate Lötverbindung mit jeweils einem Kontaktpad der Leiterplatte verbunden ist.

Aus der Leiterplattenfertigung sind verschiedene Verfahren zur Bestückung der Leiterplatten bekannt. Beispielsweise werden so genannten SMD-Bauteile (Surface Mounted Device) auf Kontaktflächen auf der Vorderseite der Leiterplatte montiert. THT-Bauteile (Through-Hole-Technology) hingegen besitzen Anschlussdrähte, welche durch eine Öffnung in der Leiterplatte gesteckt und auf der gegenüberliegenden Seite der Leiterplatte befestigt werden. Hierbei ist auch eine Mischbestückung mit SMD und THT Bauteilen möglich. Das Löten von SMD-Bauteilen erfolgt in der Regel in einem Reflowverfahren. Zur Vorbereitung hierzu wird die Leiterplatte an den zu bestückenden Stellen mit Lotpaste versehen, welche ein Lotpastendepot bildet. Anschließend wird das Bauteil auf dem entsprechenden Lotdepot positioniert. Die so bestückte Leiterplatte wird einer Wärmequelle ausgesetzt, beispielsweise auf eine Heizplatte aufgelegt oder einem Lötofen zugeführt, wobei die Lotpaste aufgeschmolzen und hierdurch eine Verbindung des Bauteils mit der Leiterplatte hergestellt wird.

Es kann vorkommen, dass Bauteile fehlerhaft sind oder im Laufe des Betriebes ausfallen. Insbesondere bei kostenintensiven Bauteilen oder bei Baugruppen mit einer Vielzahl an Bauteilen wird in einem solchen Fall nicht die komplette Baugruppe entsorgt, sondern das fehlerhafte oder defekte Bauteil ausgetauscht. Bisher werden defekte Bauteile auf bestückten Leiterplatten durch einen thermischen Prozess ausgelötet. Das Ersetzen, bzw. Wiedereinlöten erfolgt ebenfalls mittels eines thermischen Prozesses.

Von der Firma "ZEVAC" werden Maschinen vertrieben, welche ein Entfernen von Bauteilen mittels eines "Milling" genannten Verfahrens ermöglichen. Das Verfahren bietet die Möglichkeit, elektronische Bauteile mittels eines Fräsvorgangs von der Leiterplatte zu entfernen, wodurch ein thermischer Prozess vermieden wird. Der Fräskopf wird hierbei auf Höhe des Bauteils abgesenkt und anschließend eine Bewegung des Fräskopfes in x-y-Richtung durchgeführt, bis das gesamte Bauteil abgefräst ist. Die Leiterplatte wird dadurch weniger thermischem Stress ausgesetzt, wodurch einer künstlichen Alterung vorgebeugt wird.

EP0548603B1 offenbart ebenfalls das vorbeschriebene Verfahren zum Entfernen eines Bauteils von einer Leiterplatte mittels Fräsen.

Beim Entfernen bestimmter Bauteile, bspw. Ball Grid Array-Bauteilen, sind aber deutliche Nachteile aufgetreten. Beim Abfräsen unter den x-y-Vorschubrichtungen werden relativ große Kräfte wirksam, welche zu einer Verschmierung des Lotes sowie zum Abriss von Leiterbahnen oder Pads auf der Leiterplatte führen können.

Die Aufgabe der vorliegenden Erfindung besteht daher darin, eine mechanische Entfernung eines Bauteils von einer Leiterplatte zu ermöglichen, ohne dass Verschmierungen des Lotes oder Beschädigungen an Kontaktpads an Leiterbahnen und Kontaktpads der Leiterplatte beim, bzw. nach dem Entfernen des Bauteils auftreten.

Die Aufgabe wird durch ein Verfahren zum Entfernen eines auf einer Leiterplatte aufgebrachten Bauteils gemäß Anspruch 1 gelöst.

Die Aufgabe wird also durch eine Fräsung in z-Richtung gelöst. Bei der z-Achsenfräsung (Bewegung des Fräswerkzeugs orthogonal zur Ebene der Leiterplatte) wird das Fräswerkzeug durch das Bauteil hindurch zur Lötverbindung geführt. Auf diese Art und Weise kann das Bauteil nach erfolgten Durchfräsen aller Anschlüsse von der Leiterplatte abgehoben werden. Es treten keine lateralen Kräfte, also Kräfte in x-y-Richtung, auf, wie diese im aus dem Stand der Technik bekannten Verfahren aufgrund der Vorschubbewegungen in x- oder y-Richtung entstehen. Weiterhin wird das Fräswerkzeug durch das Gehäuse des Bauteils in seiner Position geführt, was einen gewissen Schutz der Lötverbindungen und Kontaktpads vor mechanischen Belastungen erreicht.

Die Lötverbindungen liegen jeweils zentrisch zum Fräswerkzeug. Somit wird nach dem Durchfräsen des Gehäuses des Bauteils direkt die Lötverbindung mit dem Fräswerkzeug entfernt. Dabei entstehen größere Krafteinwirkungen nur in Richtung der z-Achse, wodurch mechanische Beschädigungen der Kontaktpads vermieden werden.

Ein Verschmieren des weichen Lots der Lötverbindung wird ebenfalls vermieden, da keine Bewegungen in x- und y-Richtung durchgeführt werden.

Ein Kontaktpad ist eine leitfähige Fläche oder Beschichtung, insbesondere metallisch, auf der Leiterplatte, welche nach Verbindung eines Anschlusses des Bauteils den Anschluss mit einer Komponente der Leiterplatte, beispielsweise eine Leiterbahn, elektrisch verbindet.

Gemäß einer vorteilhaften Ausgestaltung des erfindungsgemäßen Verfahrens ist vorgesehen, dass die vorgegebene Höhe derart gewählt wird, dass von der jeweiligen Lötverbindung ein Restlotmenge mit definierter Dicke, insbesondere zwischen 10 µm bis 90 µm, bestehen bleibt. Bevorzugter Weise weist die Restlotmenge eine definierte Dicke zwischen 15 µm bis 50 µm. Besonders bevorzugter Weise weist die Restlotmenge eine definierte Dicke zwischen 15 µm bis 30 µm. Diese spezifische Dicke ermöglicht ein einfaches Anbringen eines neuen Bauteils. Ein geeignetes Verfahren zum Anbringen eines neuen Bauteils nach dem Entfernen des defekten Bauteils ist beispielsweise in der Patentanmeldung DE 102013112348 A1 oder in der am selben Anmeldetag wie die vorliegende Anmeldung angemeldete Patentanmeldung mit dem Titel "Stift zum Übertragen von Lotpaste aus einem Reservoir auf eine Kontaktstelle einer Leiterplatte" offenbart.

Gemäß einer bevorzugten Ausgestaltung des erfindungsgemäßen Verfahrens ist vorgesehen, dass das Bauteil eine definierte Gehäusedicke aufweist, wobei vorab mittels einer Höhenvermessung des Bauteils, insbesondere eine Laserhöhenvermessung, ein Abstand zwischen der von der Leiterplatte abgewandten Seite des Bauteils und einer Oberfläche der Leiterplatte im Umfeld des Bauteils ermittelt wird, und wobei anhand des ermittelten Abstands und der Dicke der Restlotmenge die vorgegebene Höhe ermittelt wird.

Gemäß einer vorteilhaften Ausgestaltung des erfindungsgemäßen Verfahrens ist vorgesehen, dass eine Mehrpunkt-Höhenmessung des Bauteils vorgenommen wird und anhand der Mehrpunkt-Höhenmessung eine Lageverschiebung des Bauteils bezüglich der Ebene der Leiterplatte bestimmt wird, und wobei die vorbestimmte Höhe für jeden der Anschlüsse anhand der Lageverschiebung korrigiert wird. Idealerweise sollte ein Bauteil im Wesentlichen parallel zu der Oberfläche der Leiterplatte angebracht sein (bei der vereinfachten Annahme, dass sowohl die Oberfläche der Leiterplatte, als auch die Oberfläche des Bauteils im Wesentlichen eben ausgestaltet ist). Jedoch kommt es mitunter vor, dass das Lot im Ofen bei verschiedenen Lötverbindungen unterschiedlich stark aufschmilzt. Daher kann die Dicke der Lötverbindung bei den einzelnen Anschlüssen unterschiedlich ausfallen, wodurch das Bauteil schief auf der Leiterplatte aufliegen kann. Dadurch ändert sich die vorbestimmte Höhe von Anschluss zu Anschluss, was kompensiert werden muss, um beispielsweise nicht versehentlich Teile eine Kontaktpads abzutragen, falls zu tief gefräst wird.

Gemäß einer bevorzugten Ausgestaltung des erfindungsgemäßen Verfahrens ist vorgesehen, dass das Bauteil vorab zusätzlich mittels einer Befestigungsvorrichtung an der Leiterplatte fixiert wird. Das Fräswerkzeug übt bei dem Bewegen durch das Bauteil gegebenenfalls eine leichte Rotationskraft auf das Bauteil aus. Insbesondere dann, wenn das Verfahren fortgeschritten ist und nur noch wenige Lötverbindungen bestehen, könnte sich das Bauteil durch diese Rotationskraft lösen. Dies wird durch die Befestigungsvorrichtung verhindert. Beispielsweise kann eine Klammer, die das Bauteil an die Leiterplatte klemmt, oder Knetmasse, die das Bauteil leicht an die Leiterplatte anheftet, verwendet werden.

Gemäß einer vorteilhaften Ausgestaltung des erfindungsgemäßen Verfahrens ist vorgesehen, dass Fräswerkzeug in eine Rotationsbewegung mit einer Geschwindigkeit zwischen 70.000 rpm (Umdrehungen per Minute) und 90.000 rpm versetzt wird.

Gemäß des erfindungsgemäßen Verfahrens ist vorgesehen, dass als Bauteil ein auf der Ball Grid Array-, Pin Grid Array- oder Land Grid Array-Technologie basierendes Bauteil verwendet wird. Es können beliebige weitere SMD-Bauteiltypen verwendet werden, welche eine Vielzahl von Anschlüssen aufweisen und mittels Lötverbindungen mit der Leiterplatte verbindbar sind.

Gemäß einer vorteilhaften Weiterbildung des erfindungsgemäßen Verfahrens ist vorgesehen, dass für den Fall, dass eine der Lötverbindungen um ein Vielfaches größer als die restlichen Lötverbindungen des Bauteils ist, das Fräswerkzeug oder ein weiteres Fräswerkzeug zwischen den Verfahrensschritten b) und c) die vorgegebene Höhe beibehält, bzw. auf diese gebracht wird und, insbesondere mäanderförmig, über die gesamte Fläche dieser Lötverbindung bewegt wird. Dies betrifft insbesondere Lötverbindungen, welche größer als die Größe, bzw. die effektive Fräsfläche des Fräswerkzeugs sind. Diese sind durch eine z-Bewegung im Sinne der Erfindung nicht vollständig entfernbar, da nur ein Teil der Lötverbindung erfasst werden kann. Hier wird das konventionelle, bekannte x-y-Fräsverfahren angewandt. "Größer" bedeutet in diesem Zusammenhang, dass die Kontaktfläche zwischen Lot und Kontaktpad dieser speziellen Lötverbindung flächenmäßig größer als die durchschnittliche Kontaktfläche zwischen Lot und Kontaktpads der übrigen Lötverbindungen ist.

Gemäß einer vorteilhaften Weiterbildung des erfindungsgemäßen Verfahrens ist vorgesehen, dass das Gehäuse vorab mittels eines weiteren Fräs- oder Schleifwerkzeugs auf eine vorbestimmte Dicke reduziert wird oder entfernt wird. Beispielsweise wird hierbei das konventionelle, bekannte x-y-Fräsverfahren angewandt. Dadurch wird der Fräsweg durch das Gehäuse des Bauteils reduziert, bzw. entfällt vollständig, wodurch der Verschleiß des Fräswerkzeugs reduziert wird.

Gemäß einer vorteilhaften Weiterbildung des erfindungsgemäßen Verfahrens ist vorgesehen, dass der Durchmesser des Fräswerkzeugs größer gleich dem Durchmesser der Lötverbindungen ist. Insbesondere wird hierbei der größte verfügbare Durchmesser der auf der Leiterplatte vorhandenen Lötverbindungen gewählt. Beachtet werden muss, dass dieser Durchmesser kleiner als der kleinste Abstand zwischen zwei Lötverbindungen ist, um bei einer Fräsbewegung in z-Achse nur auf eine einzelne Lötverbindung zu fräsen. Lötverbindungen, deren Durchmesser größer als der kleinste Abstand zwischen zwei Lötverbindungen ist, können dann beispielsweise mittels eines x-y-Fräsverfahrens gemäß Anspruch 8 aufgelöst werden.

Die Erfindung wird anhand der nachfolgenden Figuren näher erläutert. Es zeigen
Fig. 1: eine schematische Darstellung eines Querschnitts durch ein auf einer Leiterplatte aufgebrachtes Bauteil;
Fig. 2: eine schematische Darstellung der Unterseite des Bauteils;
Fig. 3: eine Darstellung eines Fräsverfahren zum Entfernen eines Bauteils von einer Leiterplatte gemäß dem Stand der Technik;
Fig. 4: eine weitere Darstellung des Fräsverfahren zum Entfernen eines Bauteils von einer Leiterplatte gemäß dem Stand der Technik;
Fig. 5: eine schematische Darstellung eines Ausführungsbeispiel des erfindungsgemäßen Verfahren;
Fig. 6: eine schematische Darstellung einer ersten Weiterbildung des erfindungsgemäßen Verfahrens; und
Fig. 7: eine schematische Darstellung einer zweiten Weiterbildung des erfindungsgemäßen Verfahrens.

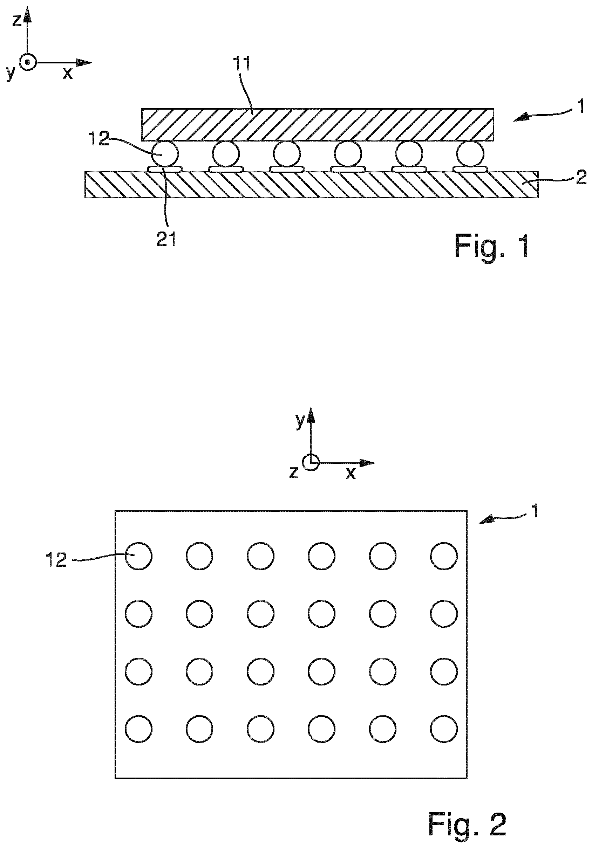

In Fig. 1 ist ein Bauteil 1 gezeigt, welches auf einer Leiterplatte 2 aufgebracht ist. Die Oberfläche der Leiterplatte 2 definiert eine Ebene in x- und y-Richtung. Orthogonal zu dieser Ebene liegt eine z-Richtung. Dieses definierte Koordinatensystem wird im Zusammenhang mit der gesamten Erfindung verwendet.

Die Leiterplatte umfasst eine Vielzahl von Kontaktpads 21, beispielsweise aus Kupfer, welche mit Leiterbahnen verbunden sind. Als Bauteil 1 wird in diesem Beispiel ein Ball-Grid-Array-Bauteil verwendet. Dieses weist eine Vielzahl von Anschlüssen auf, welche an einer Unterseite des Gehäuses des Bauteils 1 angebracht sind und welche beispielsweise in einem zweidimensionalen Raster angeordnet sind. Das Gehäuse umschließt die Elektronik des Bauteils. Jedem Anschluss ist ein eine Lotperle zugeordnet. Diese Lotperlen werden beim Reflow-Löten oder Dampfphasen- Löten in einem Lötofen aufgeschmolzen und verbinden sich mit den Kontaktpads 21 auf der Leiterplatte 2, wodurch die Lötverbindungen 12 gebildet werden. Ein Beispiel für ein solches Raster ist in Fig. 2 gezeigt, in welcher die Unterseite des Bauteils abgebildet ist.

Nach Aufbringen des Bauteils 1 auf der Leiterbahn 2 wird dieses getestet, insbesondere elektronisch getestet und/oder optisch analysiert. Stellt sich heraus, dass das Bauteil 1 nicht funktionsgemäß arbeitet, beispielsweise durch eine Beschädigung des Bauteils 1 oder durch eine fehlerhafte Lötverbindung 12, so ist oftmals die gesamte Leiterplatte 1 unbrauchbar. Da eine Leiterplatte 1 oftmals eine Vielzahl solcher Bauteile 1 aufweist, ist ein Entsorgen der gesamten Leiterplatte 1, insbesondere aus Kostengründen, keine Option. Es ist daher wünschenswert, das defekte Bauteil 1 zu entfernen, und zwar derart, dass auf selber Stelle auf der Leiterplatte 1 ein neues, funktionsfähiges Bauteil aufgebracht werden kann.

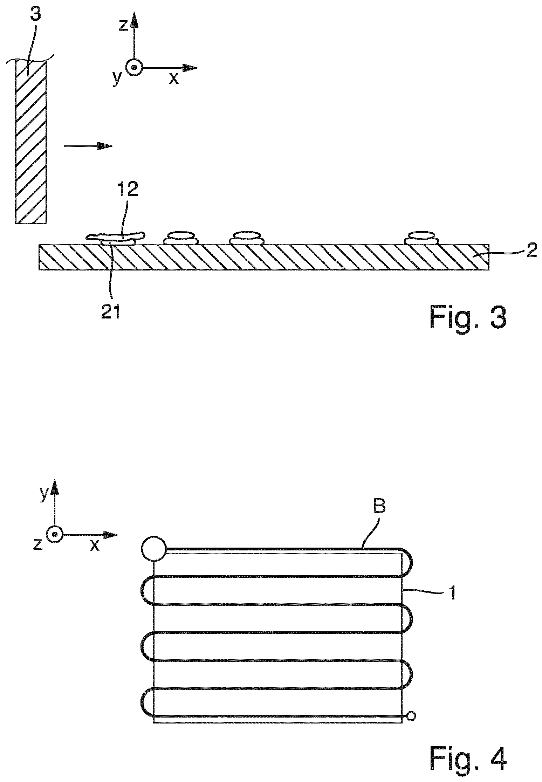

Ein Verfahren zum Entfernen eines solchen defekten Bauteils, welches aus dem Stand der Technik bekannt ist, ist in Fig. 3 und Fig. 4 gezeigt. Das Verfahren umfasst ein Verwenden eines Fräswerkzeugs. Dieses wird in Nähe der Leiterplatte gebracht. Anschließend wird das Bauteil in einer x-y-Bewegung B, beispielsweise mäanderförmig, abgetragen. Problematisch hierbei ist jedoch, dass das relativ weiche Lotmaterial verschmieren kann (siehe Lotverbindung 21 ganz links in Fig. 3) und dass durch die mitunter großen Kräfte in x-, bzw. y-Richtung ein Abreißen eines Kontaktpads (siehe die Leerstelle zwischen den Kontaktpads 21 rechts in Fig. 3) auftreten kann.

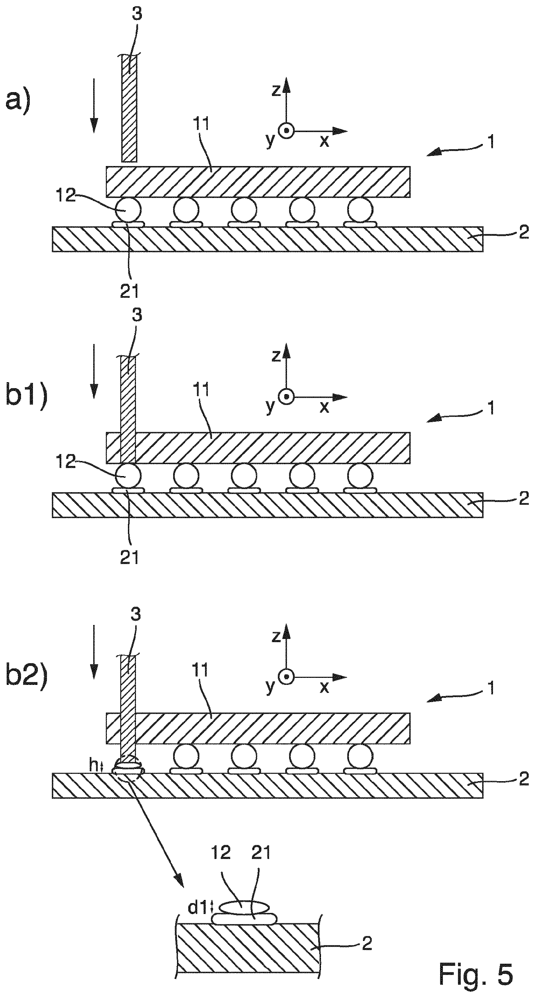

In Fig. 5 ist ein Ausführungsbeispiel des erfindungsgemäßen Verfahrens gezeigt, bei welchem diese beschriebenen Nachteile des aus dem Stand der Technik bekannten Verfahrens nicht auftreten. Das Verfahren besteht im Kern daraus, dass lediglich eine Fräsbewegung in z-Richtung zum Auflösen der Lötverbindungen 12 ausgeführt wird, wodurch keine lateralen Kräfte auf die Lötverbindungen 12, bzw. auf die Kontaktpads 21, einwirken.

In einem ersten Verfahrensschritt a) wird die Leiterplatte 2 mit dem bestückten Bauteil 1 in eine Fräsvorrichtung eingelegt. Anschließend wird das Bauteil 1 analysiert, insbesondere optisch, um das Höhenprofil des Bauteils 1 auf der Leiterplatte 2 zu detektieren. Dies dient dem Zweck, eine eventuelle Höhenverschiebung des Bauteils 1 gegenüber der idealen Lage des Bauteils 1 auf der Leiterplatte (idealerweise sollte das Bauteil parallel zur Oberfläche der Leiterplatte angebracht sein) festzustellen.

Anschließend wird eine vorbestimmte Höhe h über der Leiterplatte 2 in z-Richtung bestimmt, also eine Tiefe in z-Richtung von der Ausgangsposition des Fräswerkzeugs aus, in welche sich das Fräswerkzeug 3 bewegen soll. Diese Höhe wird derart gewählt, dass eine vorbestimmte Dicke d1 der Lotverbindung 21 nach dem Fräsen bestehen bleibt. Berechnet werden kann diese Höhe, indem der Abstand zwischen der oberen Seite des Gehäuses über der Leiterplatte gemessen wird und davon die bekannte Dicke des Gehäuses und die gewünschte Dicke d1 des Restlots abgezogen wird. Anschließend wird das vorher bestimmte Höhenprofil herangezogen und die berechnete Höhe h entsprechend angepasst, um die Höhenverschiebung zu kompensieren. Dies wird für alle Lötverbindungen 12 einzeln durchgeführt.

Anschließend steuert das Fräswerkzeug 3 die erste Lötverbindung auf der x-y-Ebene an. Dabei befindet sich das Fräswerkzeug in einer Ausgangsposition, in welcher das Fräswerkzeug 3 sich derart abgesetzt von der Leiterplatte 2 in z-Richtung befindet, dass das Fräswerkzeug 3 weder die Leiterplatte 2 noch das Bauteil 1 berührt. Die Lage der Lötverbindungen 12 auf der x-y-Ebene ist in der Software der Fräsvorrichtung programmierbar.

Das Fräswerkzeug 3 wird in einem zweiten Verfahrensschritt b) in Rotationsbewegung versetzt. Anschließend wird das Fräswerkzeug 3 in z-Richtung in Richtung Leiterplatte 2 abgesenkt. Dabei fräst sich das Fräswerkzeug 3 zuerst durch das Gehäuse 11 des Bauteils (siehe Fig. 5 b1)). Das Fräswerkzeug 3 wird weiter abgesenkt und fräst sich durch die Lötverbindung 12, bis es an der vorbestimmten Höhe angelangt (siehe Fig. 5 b2)).

Anschließend wird das Fräswerkzeug 3 in einem Verfahrensschritt c) wieder angehoben und auf die Ausgangsposition zurückgeführt. Die Lötverbindung 12 zwischen dem Bauteil 1 und der Leiterplatte 2 existiert nun nicht mehr. Es ist nur noch die gewünschte Menge an Restlot auf dem Kontaktpad 21 vorhanden.

Im abschließenden Verfahrensschritt d) werden die vorher beschriebenen Verfahrensschritte a) bis c) für jeder der noch existierenden Lötverbindungen wiederholt. Anschließend ist das Bauteil 1 abhebbar. Auf die nun verbleibenden Kontaktpads 21 mit den jeweiligen Restlotmengen ist nun ein neues Bauteil aufbringbar.

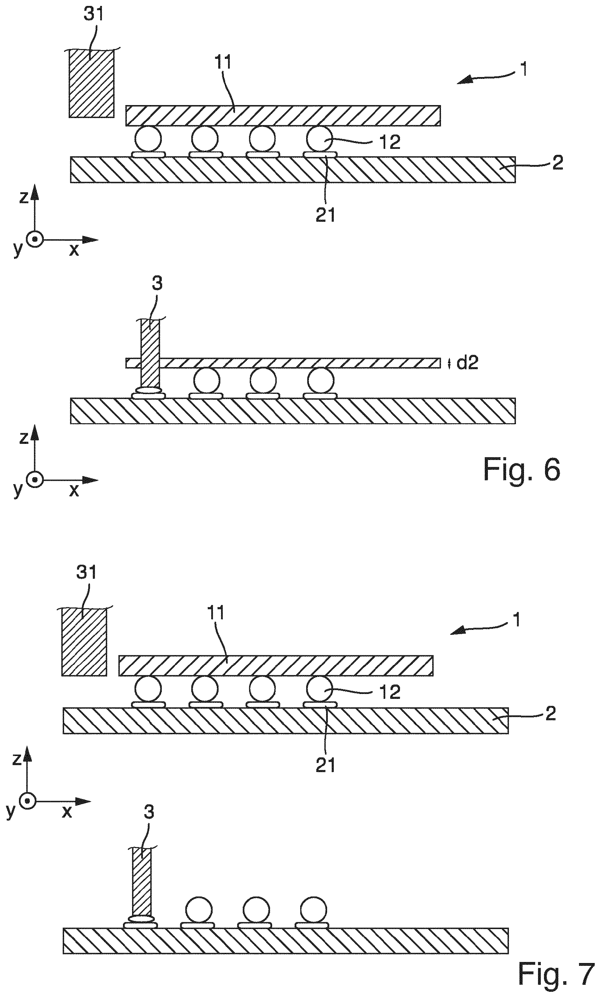

In Fig. 6 ist eine erste Weiterbildung des erfindungsgemäßen Verfahrens abgebildet. Hierbei wird das Gehäuse 11 vorab abgeschliffen, bzw. abgefräst, bis eine vorbestimmte Dicke d2 erreicht ist. Hierfür wird ein zum Fräswerkzeug 3 verschiedenes Fräswerkzeug 31, bzw. ein Schleifwerkzeug verwendet. Beispielsweise wird das Gehäuse 11 analog des bekannten x-y-Fräsens abgetragen. Anschließend werden die Verfahrensschritte a) bis d) durchgeführt.

In Fig. 7 ist eine zweite Weiterbildung des erfindungsgemäßen Verfahrens abgebildet. Hierbei wird das Gehäuse 11 vorab komplett abgeschliffen, bzw. abgefräst. Hierfür wird ein zum Fräswerkzeug 3 verschiedenes Fräswerkzeug 31, bzw. ein Schleifwerkzeug verwendet. Beispielsweise wird das Gehäuse 11 analog des bekannten x-y-Fräsens abgetragen. Anschließend werden die Verfahrensschritte a) bis d) durchgeführt, wobei nun nur noch durch die verbleibenden Lötverbindungen 12 selbst gefräst wird.

Mittels beiden Weiterbildungen kann das Fräswerkzeug 3 geschont werden, da die Frässtrecke durch das Gehäuse 11 reduziert wird, bzw. komplett entfällt.

### Bezugszeichenliste

- 1: Bauteil
- 11: Gehäuse
- 12: Lötverbindung
- 2: Leiterplatte
- 21: Kontaktpad
- 3: Fräswerkzeug
- 31: weiteres Fräswerkzeug
- d1: definierte Dicke des Restlots
- d2: vorabbestimmte Dicke des verbleibenden Gehäuses
- B: Bewegung
- h: vorgegebene Höhe
- x-y: x-y-Ebene
- z: z-Richtung, orthogonal zur Leiterplatte (x-y-Ebene)

## Patentansprüche

1. Verfahren zum Entfernen eines auf einer Leiterplatte (2) aufgebrachten Bauteils (1), wobei als Bauteil (1) ein auf der Ball Grid Array- oder Land Grid Array-Technologie basierendes Bauteil verwendet wird, wobei das Bauteil (1) ein Gehäuse (11) und eine Vielzahl von Anschlüssen aufweist, wobei jeder der Anschlüsse über eine separate Lötverbindung (12) mit jeweils einem Kontaktpad der Leiterplatte (2) verbunden ist, umfassend:
a) Positionieren eines Fräswerkzeugs (3) über der Position eines ersten Anschlusses, wobei sich das Fräswerkzeug (3) in einer die Leiterplatte (2) nicht berührenden Ausgangshöhe über der Leiterplatte (2) oberhalb des Bauteils (1) befindet;
b) Versetzen des Fräswerkzeugs (3) in Rotationsbewegung und Bewegen des Fräswerkzeugs (3) durch das Bauteil (1) hindurch in einer zu der Oberfläche der Leiterplatte (2) im Wesentlichen orthogonalen Richtung (z) auf eine vorgegebene Höhe (h) über der Leiterplatte (2);
c) Zurückbewegen des Fräswerkzeugs (3) auf die Ausgangshöhe;
d) Wiederholen der Verfahrensschritte a) bis c) für die weiteren Anschlüsse.

2. Verfahren nach Anspruch 1, wobei die vorgegebene Höhe (h) derart gewählt wird, dass von der jeweiligen Lötverbindung (12) ein Restlotmenge mit definierter Dicke (d1), insbesondere zwischen 10 µm bis 90 µm, bestehen bleibt.

3. Verfahren nach Anspruch 2, wobei das Bauteil (1) eine definierte Gehäusedicke aufweist, wobei vorab mittels einer Höhenvermessung des Bauteils (1), insbesondere eine Laserhöhenvermessung, ein Abstand zwischen der von der Leiterplatte (2) abgewandten Seite des Bauteils (1) und einer Oberfläche der Leiterplatte (2) im Umfeld des Bauteils (1) ermittelt wird, und wobei anhand des ermittelten Abstands und der Dicke (d1) der Restlotmenge die vorgegebene Höhe (h) ermittelt wird.

4. Verfahren nach zumindest einem der vorherigen Ansprüche, wobei eine Mehrpunkt-Höhenmessung des Bauteils (1) vorgenommen wird und anhand der Mehrpunkt-Höhenmessung eine Lageverschiebung des Bauteils (1) bezüglich der Ebene der Leiterplatte (2) bestimmt wird, und wobei die vorbestimmte Höhe (h) für jeden der Anschlüsse anhand der Lageverschiebung korrigiert wird.

5. Verfahren nach zumindest einem der vorherigen Ansprüche, wobei das Bauteil (1) vorab zusätzlich mittels einer Befestigungsvorrichtung an der Leiterplatte (2) fixiert wird.

6. Verfahren nach zumindest einem der vorherigen Ansprüche, wobei das Fräswerkzeug (3) in eine Rotationsbewegung mit einer Geschwindigkeit zwischen 70.000 rpm und 90.000 rpm versetzt wird.

7. Verfahren nach zumindest einem der vorherigen Ansprüche, wobei für den Fall, dass eine der Lötverbindungen um ein Vielfaches größer als die restlichen Lötverbindungen (12) des Bauteils (1) ist, das Fräswerkzeug (3) oder ein weiteres Fräswerkzeug (31) zwischen den Verfahrensschritten b) und c) die vorgegebene Höhe (h) beibehält, bzw. auf diese gebracht wird und, insbesondere mäanderförmig, über die gesamte Fläche dieser Lötverbindung bewegt (B) wird.

8. Verfahren nach zumindest einem der vorherigen Ansprüche, wobei das Gehäuse (11) vorab mittels eines weiteren Fräs- oder Schleifwerkzeugs (31) auf eine vorbestimmte Dicke (d2) reduziert wird oder entfernt wird.

9. Verfahren nach zumindest einem der vorherigen Ansprüche, für das Fräswerkzeug (3) ein Durchmesser gewählt wird, welcher größer gleich dem Durchmesser der Lötverbindungen (12) ist.

## Claims

1. A method of removing a component (1) applied to a printed circuit board (2), wherein the component (1) used is a component based on ball grid array or land grid array technology, the component (1) having a housing (11) and a plurality of terminals, each of the terminals being connected to a respective contact pad of the printed circuit board (2) via a separate solder connection (12), comprising:
a) Positioning a milling tool (3) above the position of a first connection, the milling tool (3) being located above the printed circuit board (2) above the component (1) at an initial height not touching the printed circuit board (2);
b) Setting the milling tool (3) in rotational motion and moving the milling tool (3) through the component (1) in a direction (z) essentially orthogonal to the surface of the printed circuit board (2) to a predetermined height (h) above the printed circuit board (2);
c) Move the milling tool (3) back to the starting height;
d) Repeat process steps a) to c) for the other connections.

2. Method according to claim 1, wherein the predetermined height (h) is selected such that a residual amount of solder with a defined thickness (d1), in particular between 10 µm and 90 µm, remains from the respective solder joint (12).

3. Method according to claim 2, wherein the component (1) has a defined housing thickness, wherein a distance between the side of the component (1) facing away from the printed circuit board (2) and a surface of the printed circuit board (2) in the vicinity of the component (1) is determined in advance by means of a height measurement of the component (1), in particular a laser height measurement, and wherein the predetermined height (h) is determined on the basis of the determined distance and the thickness (d1) of the residual solder quantity.

4. Method according to at least one of the preceding claims, wherein a multipoint height measurement of the component (1) is carried out and a positional displacement of the component (1) with respect to the plane of the printed circuit board (2) is determined on the basis of the multipoint height measurement, and wherein the predetermined height (h) for each of the terminals is corrected on the basis of the positional displacement.

5. Method according to at least one of the preceding claims, wherein the component (1) is additionally fixed to the printed circuit board (2) in advance by means of a fixing device.

6. Method according to at least one of the preceding claims, wherein the milling tool (3) is set into a rotational movement at a speed of between 70,000 rpm and 90,000 rpm.

7. Method according to at least one of the preceding claims, wherein, in the event that one of the soldered joints is many times larger than the remaining soldered joints (12) of the component (1), the milling tool (3) or a further milling tool (31) maintains the predetermined height (h) between method steps b) and c) or is brought to this height and is moved (B), in particular in a meandering manner, over the entire surface of this soldered joint.

8. Method according to at least one of the preceding claims, wherein the housing (11) is reduced to a predetermined thickness (d2) or removed in advance by means of a further milling or grinding tool (31).

9. Method according to at least one of the preceding claims, a diameter is selected for the milling tool (3) which is greater than or equal to the diameter of the solder joints (12).

## Revendications

1. Procédé pour enlever un composant (1) appliqué sur une carte de circuit imprimé (2), dans lequel on utilise comme composant (1) un composant basé sur la technologie Ball Grid Array ou Land Grid Array, dans lequel le composant (1) présente un boîtier (11) et une pluralité de connexions, chacune des connexions étant reliée par une connexion soudée séparée (12) à respectivement un plot de contact de la carte de circuit imprimé (2), comprenant :
a) le positionnement d'un outil de fraisage (3) au-dessus de la position d'une première borne, l'outil de fraisage (3) se trouvant à une hauteur initiale au-dessus de la carte de circuit imprimé (2) au-dessus du composant (1), sans contact avec la carte de circuit imprimé (2) ;
b) mettre l'outil de fraisage (3) en mouvement de rotation et déplacer l'outil de fraisage (3) à travers le composant (1) dans une direction (z) sensiblement orthogonale à la surface de la carte de circuit imprimé (2) jusqu'à une hauteur prédéterminée (h) au-dessus de la carte de circuit imprimé (2) ;
c) Retour de l'outil de fraisage (3) à la hauteur initiale ;
d) Répéter les étapes a) à c) du procédé pour les autres raccords.

2. Procédé selon la revendication 1, dans lequel la hauteur prédéfinie (h) est choisie de telle sorte qu'il reste une quantité de brasure résiduelle d'une épaisseur définie (d1), en particulier comprise entre 10 µm et 90 µm, de l'assemblage brasé respectif (12).

3. Procédé selon la revendication 2, dans lequel le composant (1) présente une épaisseur de bo tier définie, une distance entre le côté du composant (1) opposé à la carte de circuit imprimé (2) et une surface de la carte de circuit imprimé (2) dans l'environnement du composant (1) étant déterminée au préalable au moyen d'une mesure de hauteur du composant (1), en particulier une mesure de hauteur au laser, et la hauteur prédéfinie (h) étant déterminée à l'aide de la distance déterminée et de l'épaisseur (d1) de la quantité de soudure résiduelle.

4. Procédé selon au moins l'une des revendications précédentes, dans lequel on effectue une mesure de hauteur multipoints du composant (1) et on détermine, à l'aide de la mesure de hauteur multipoints , un décalage de position du composant (1) par rapport au plan du circuit imprimé (2), et dans lequel on corrige la hauteur prédéterminée (h) pour chacune des connexions à l'aide du décalage de position.

5. Procédé selon au moins l'une des revendications précédentes, dans lequel le composant (1) est préalablement fixé en outre à la carte de circuit imprimé (2) au moyen d'un dispositif de fixation.

6. Procédé selon au moins l'une des revendications précédentes, dans lequel l'outil de fraisage (3) est animé d'un mouvement de rotation à une vitesse comprise entre 70 000 rpm et 90 000 rpm.

7. Procédé selon au moins l'une des revendications précédentes, dans lequel, dans le cas où l'un des joints brasés est plusieurs fois plus grand que les autres joints brasés (12) de l'élément de construction (1), l'outil de fraisage (3) ou un autre outil de fraisage (31) conserve la hauteur prédéterminée (h) entre les étapes b) et c) du procédé, ou est amené à cette hauteur et est déplacé (B), notamment en forme de méandres, sur toute la surface de ce joint brasé.

8. Procédé selon au moins l'une des revendications précédentes, dans lequel le boîtier (11) est préalablement réduit ou enlevé à une épaisseur prédéterminée (d2) au moyen d'un autre outil de fraisage ou de meulage (31).

9. Procédé selon au moins l'une des revendications précédentes, on choisit pour l'outil de fraisage (3) un diamètre supérieur ou égal au diamètre des joints brasés (12).
